# FASCICULE DE BREVET EUROPEEN

(11) **EP 4 478 854 B1**
(45) Date de publication et mention de la délivrance du brevet: **22.10.2025**
(21) Numéro de dépôt: 24181324.5
(22) Date de dépôt: 11.06.2024
(51) Int. Cl.: H05K 7/20

(54) **ARMOIRE DE CONTRÔLEUR DE ROBOT ET ROBOT COMPRENANT UNE TELLE ARMOIRE**
ROBOTERSTEUERUNGSSCHRANK UND ROBOTER MIT EINEM SOLCHEN ROBOTERSTEUERUNGSSCHRANK
CABINET FOR ROBOT CONTROLLER AND ROBOT COMPRISING SUCH CABINET

(30) Priorité: 12.06.2023 FR 2305899
(43) Date de publication de la demande: 18.12.2024
(73) Titulaire: Staubli Faverges, 74210 Faverges-Seythenex (FR)
(72) Inventeur: BOUCHET, Corentin, 74210 Faverges-Seythenex (FR); ANNI, Germano, 25025 Manerbio (BS) (IT); SALLEYRETTE, Benoit, 74210 Doussard (FR)
(74) Mandataire: Lavoix

(56) Documents cités:
- EP-A1- 3 079 451
- WO-A1-2012/077374

## Description

La présente invention concerne une armoire de contrôleur de robot, ainsi qu'un robot comprenant une telle armoire.

L'invention a trait au domaine des robots industriels qui comprennent généralement un bras de robot, un contrôleur de robot et des câbles de transmission permettant de relier le bras de robot au contrôleur.

Le bras de robot est généralement constitué de plusieurs éléments articulés et mobiles les uns par rapport aux autres grâce à des moteurs électriques munis de capteurs aptes à donner leur position. Le contrôleur de robot rassemble, dans une armoire distincte du bras de robot, l'ensemble des composants électroniques aptes à déterminer et fournir les consignes de commandes du bras de robot.

L'armoire de contrôleur de robot présente deux fonctionnalités qui sont de contenir les composants électroniques nécessaires au fonctionnement du bras de robot et d'assurer de bonnes conditions de fonctionnement de ces composants électroniques.

En effet, certains composants électroniques nécessaires à la commande du bras de robot, comme des amplificateurs, produisent une grande quantité de chaleur au cours de leur utilisation, alors que d'autres composants comme les processeurs ne fonctionnent correctement que lorsque la température dans l'armoire n'est pas trop élevée.

Pour assurer le bon fonctionnement de l'ensemble de ces composants, des armoires de contrôleur de robot, par exemple connues de EP3079451A1 et WO2012/077374A1, comprennent des éléments de refroidissements en contact thermique direct avec les composants électroniques et avec un canal de refroidissement. D'autre part, ces armoires séparent, au sein de deux chambres distinctes, les composants électroniques générant de la chaleur et les composants électroniques dont le fonctionnement doit se faire dans une certaine gamme de température.

Ces armoires séparant les composants éléctroniques en deux chambres différentes présentent le désavantage d'être assez coûteuses et encombrantes.

L'invention vise donc à remédier à cet inconvénient en fournissant une nouvelle armoire de contrôleur de robot permettant le fonctionnement optimal des composants électroniques, tout en étant compacte.

L'invention a pour objet une armoire de contrôleur de robot comprenant une chambre définie par un panneau supérieur, un panneau inférieur, deux panneaux latéraux, un panneau arrière et un panneau avant placé en regard du panneau arrière et définissant une face avant de l'armoire de contrôleur de robot, au moins une première unité électronique montée sur le panneau arrière de la chambre, à l'intérieur de la chambre, et comprenant au moins un composant électronique à haute densité de chaleur, au moins une deuxième unité électronique montée sur le ou les panneaux latéraux ou le panneau supérieur, à l'intérieur de la chambre, et comprenant au moins un composant électronique à densité de chaleur modérée. Cette armoire de contrôleur de robot comprend également un canal de refroidissement comprenant une ouverture d'entrée et au moins un ventilateur apte à aspirer l'air extérieur par une ouverture d'entrée du canal de refroidissement et à le refouler vers l'extérieur par une ouverture de sortie située à l'extrémité opposée à l'ouverture d'entrée du canal de refroidissement. Elle comprend en outre au moins un échangeur thermique air-composant associé à une première unité électronique et recevant, sur un premier côté au moins un composant électronique à haute densité de chaleur et portant sur un deuxième côté au moins un élément de refroidissement disposé dans le canal de refroidissement. Conformément à l'invention, le canal de refroidissement comprend une première portion définie entre le panneau inférieur de la chambre et un panneau parallèle extérieur définissant un fond de l'armoire de contrôleur de robot et une deuxième portion contigüe à la première portion, située entre le panneau arrière de la chambre et un panneau parallèle extérieur définissant une face arrière de l'armoire de contrôleur de robot. L'ouverture d'entrée du canal de refroidissement est ménagée sur la face avant de l'armoire. Un échangeur air-air croisé est disposé dans le canal de refroidissement et comprend un premier circuit de refroidissement présentant une ouverture d'entrée traversant le panneau inférieur de la chambre et une ouverture de sortie traversant le panneau inférieur de la chambre et un deuxième circuit de refroidissement présentant une ouverture d'entrée en regard de l'ouverture d'entrée du canal de refroidissement et une ouverture de sortie parallèle à l'ouverture d'entrée du deuxième circuit de refroidissement, étant agencée à l'extrémité opposé de l'échangeur air-air croisé et débouchant dans le canal de refroidissement. Au moins un ventilateur situé à l'intérieur de la chambre en regard de l'ouverture d'entrée ou de l'ouverture de sortie du premier circuit de refroidissement de l'échangeur air-air croisé génère, dans le premier circuit de refroidissement, un flux d'air perpendiculaire à un flux d'air généré dans le deuxième circuit de refroidissement par le ventilateur du canal de refroidissement.

Grâce à l'invention, l'armoire de contrôleur de robot comprend une seule chambre comportant à la fois des composants électroniques à haute densité de chaleur et des composants électroniques à densité de chaleur modérée tout en assurant grâce à l'échangeur air-air croisé que la chaleur produite par les composants à haute densité de chaleur affecte de façon limitée les composants à densité de chaleur modérée qui ne peuvent pas fonctionner correctement lorsque la température au sein de la chambre est trop élevée. En comprenant une unique chambre pour recevoir l'ensemble des composants électroniques, l'armoire de contrôleur de robot est compacte.

Au sens de la présente invention, un composant électronique à haute densité de chaleur est un composant électronique qui dissipe une puissance thermique importante compte tenu de ses dimensions. Cette dissipation de puissance importante étant concentrée sur une petite quantité de matière, elle entraîne une augmentation significative de la température du composant. Un composant éléctronique à haute densité de chaleur dissipe par exemple une puissance thermique allant de 20 Watt à 200 Watt. Par ailleurs, un composant électronique à densité de chaleur modérée est un composant électronique qui dissipe une puissance thermique faible mais dont l'augmentation de température doit être limitée pour qu'il fonctionne correctement, c'est-à-dire qui dissipe par exemple une puissance thermique inférieure à 35 Watt.

Suivant d'autres aspects avantageux de l'invention, l'armoire de contrôleur de robot comprend une ou plusieurs des caractéristiques suivantes, prises isolément ou suivant toutes les combinaisons techniquement possibles :
- Le ventilateur du canal de refroidissement est placé en aval de l'échangeur air-air croisé, en amont de l'échangeur thermique air-composant et dans la deuxième portion du canal de refroidissement.
- La première unité électronique est un amplificateur et le composant à haute densité de chaleur est un module de commutation, de préférence un transistor bipolaire à grille isolée.
- La première unité électronique est une alimentation et le composant à haute densité de chaleur est un transistor à effet de champ à grille isolée ou un thyristor ou un élément de convertisseur DC-DC qui convertit une source de courant continu d'un niveau de tension spécifié à un autre niveau de tension différent.
- La deuxième unité électronique est une unité de calcul et le composant à densité de chaleur modérée est un processeur, ou la deuxième unité électronique est une unité de filtrage et le composant à densité de chaleur modérée est un composant passif de filtrage.
- L'armoire de contrôleur de robot comprend une résistance de freinage, montée sur le panneau arrière de la chambre dans le canal de refroidissement en aval de l'échangeur thermique air-composant, configurée pour dissiper un surplus d'énergie produit par la première unité électronique.
- L'ouverture de sortie du canal de refroidissement est ménagée sur la face arrière de l'armoire de contrôleur de robot.
- La deuxième unité électronique est disposée à l'intérieur d'un premier tiroir porté par le panneau supérieur de la chambre, le premier tiroir comprenant une première ouverture, disposée en regard d'une face latérale de la chambre, et une deuxième ouverture disposée en regard de l'autre face latérale de la chambre.
- Un panneau latéral de la chambre comprend une ouverture fermée par une porte et la deuxième unité électronique est placée sur le panneau supérieur de la chambre et/ou est portée par la porte du panneau latéral.

L'invention concerne également un robot multi-axes comprenant un bras de robot articulé à au moins deux degrés de liberté, une armoire de contrôleur de robot telle que mentionnée ci-dessus et des câbles reliant le bras de robot à l'armoire de contrôleur de robot.

L'invention apparaîtra plus clairement à la lecture de la description qui va suivre, donnée uniquement à titre d'exemple non limitatif, et faite en référence aux dessins dans lesquels :
[Fig. 1] la figure 1 est une vue en perspective d'un robot multi-axes conforme à l'invention comprenant un bras articulé et une armoire de contrôleur de robot également conforme à l'invention ;
[Fig. 2] la figure 2 est une vue en perspective avec un arrachement partiel de l'armoire de contrôleur du robot de la figure 1 ;
[Fig. 3] la figure 3 est une vue en perspective par l'arrière de l'armoire de contrôleur de robot de la figure 2,
[Fig. 4] la figure 4 est une vue en coupe suivant le plan P1 visible à la figure 2 ;
[Fig. 5] la figure 5 est une vue en coupe suivant le plan P2 visible à la figure 2 ;
[Fig. 6] la figure 6 est une vue en perspective d'un échangeur air-air croisé de l'armoire de contrôleur de robot des figures 2 à 5, l'insert A) illustre un premier circuit de refroidissement d'air et l'insert B) un deuxième circuit de refroidissement d'air ;
[Fig. 7] la figure 7 est une vue en perspective d'un échangeur thermique air-composant et d'une partie de la structure de l'armoire de contrôleur de robot des figures 2à 5,
[Fig. 8] la figure 8 est une vue en perspective, analogue à la figure 2, d'une armoire de contrôleur de robot selon un deuxième mode de réalisation de l'invention.

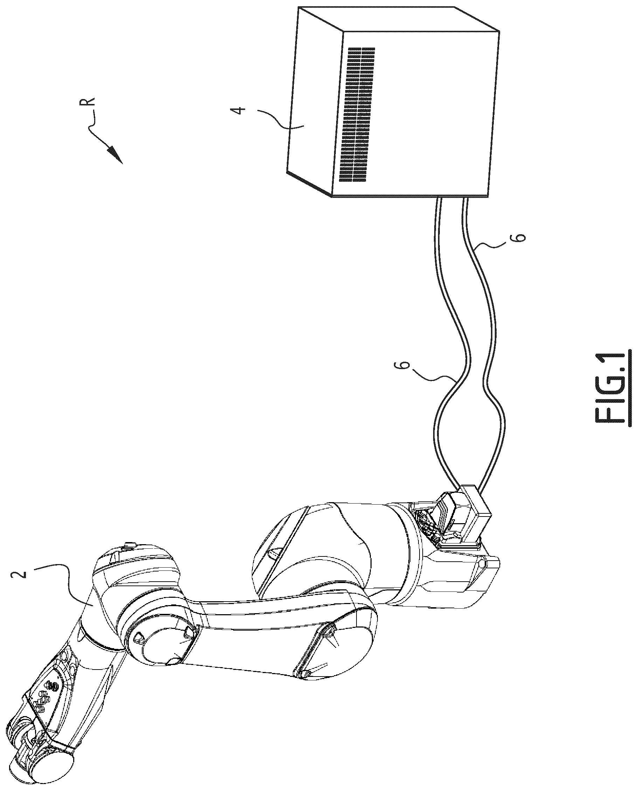

Le robot R représenté sur la figure 1 comprend un bras de robot 2 constitué de plusieurs tronçons articulés et mobiles les uns par rapport aux autres grâce à des moteurs électriques non représentés. Le robot R comprend également une armoire de contrôleur de robot 4 qui contient des unités électroniques qui implémentent
- une unité de calcul apte à déterminer des consignes de commande des moteurs à partir d'un programme applicatif,
- des amplificateurs aptes à générer les courants dans les moteurs à partir des consignes de commande des moteurs et des informations de positions des moteurs du bras de robot,
- une alimentation apte à fournir aux amplificateurs et à l'unité de calcul les tensions nécessaires à partir de la tension du réseau électrique.
Le robot R comprend également des câbles électriques 6 qui relient le bras de robot 2 à l'armoire de contrôleur de robot 4 et qui transmettent les courants aux moteurs et les signaux de position des moteurs du bras de robot 2 vers l'armoire de contrôleur de robot 4.

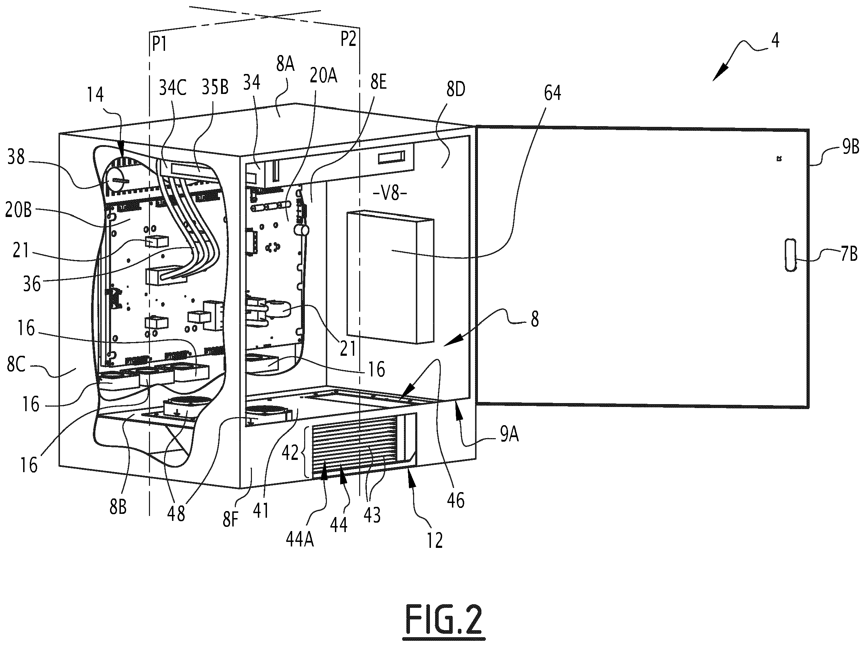

L'armoire de contrôleur de robot 4 est illustrée en détail sur les figures 2 à 5. L'armoire de robot 4 comprend une chambre 8 définie par un panneau supérieur 8A, un panneau inférieur 8B, un premier panneau latéral 8C, un deuxième panneau latéral 8D, un panneau arrière 8E et un panneau avant 8F. Le panneau avant 8F est placé en regard du panneau arrière 8E et définit une face avant 4A de l'armoire de contrôleur de robot 4.

Les panneaux 8A, 8B, 8C, 8D, 8E, 8F définissent ensemble le volume intérieur V8 de la chambre 8 de l'armoire de contrôleur de robot 4.

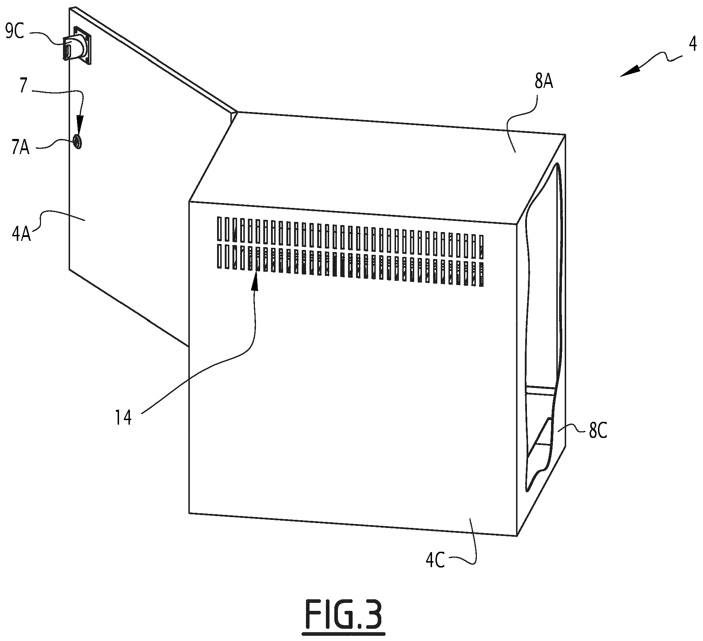

Le panneau avant 8F comprend une ouverture 9A. L'ouverture 9A est fermée par une porte 9B articulée sur le panneau avant 8F. La porte 9B peut être actionnée depuis l'extérieur de l'armoire de contrôleur de robot 4 et comporte un sectionneur 9C visible sur la figure 3. Lorsque la porte 9B est placée en position ouverte comme sur les figures 2 et 3, il est possible d'accéder depuis l'extérieur de l'armoire au volume intérieur V8 de la chambre 8. La porte 9B porte une serrure batteuse 7 comprenant une manette 7A sur la face avant 4A de l'armoire de contrôleur de robot et un pêne 7B permettant par son actionnement de maintenir la porte 9B en position fermée. Lorsque la porte 9B est fermée, le volume intérieur V8 de la chambre 8 est étanche.

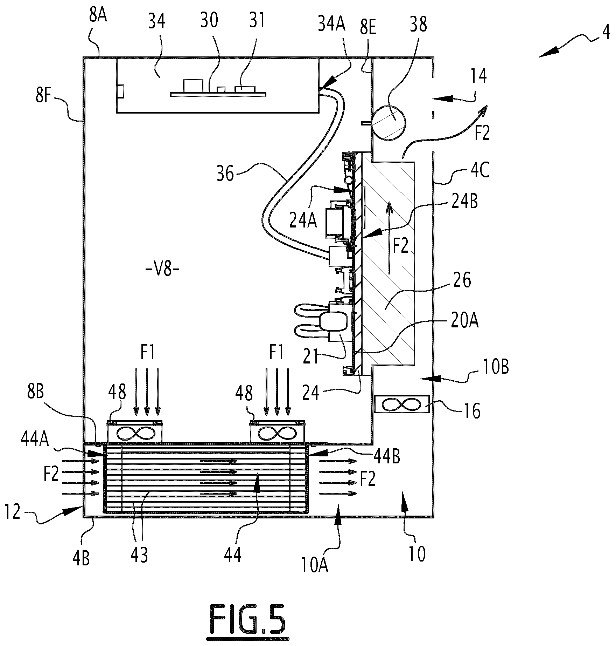

L'armoire de contrôleur de robot 4 comprend un canal de refroidissement 10, visible sur la figure 5. Le canal de refroidissement 10 comprend une première portion 10A définie entre le panneau inférieur 8B de la chambre 8 et un panneau extérieur 4B, parallèle au panneau inférieur 8B. Le panneau parallèle extérieur 4B définit un fond de l'armoire de contrôleur de robot 4. Le canal de refroidissement 10 comprend une deuxième portion 10B définie entre le panneau arrière 8E de la chambre 8 et un panneau extérieur 4C, parallèle au panneau arrière 8E. Le panneau parallèle extérieur 4C définit une face arrière de l'armoire de contrôleur de robot 4. Le canal de refroidissement 10 est également délimité par le premier panneau latéral 8C et le deuxième panneau latéral 8D.

Les deux portions 10A et 10B du canal de refroidissement sont contigües et forment un angle droit au niveau de leur jonction, en partie arrière basse de l'armoire de contrôleur de robot 4.

Le canal de refroidissement 10 comprend une ouverture d'entrée 12 ménagée sur la face avant 4A de l'armoire de contrôleur de robot 4 et une ouverture de sortie 14 située à l'extrémité opposée à l'ouverture d'entrée du canal de refroidissement 10 et ménagée sur la face arrière 4C de l'armoire de contrôleur de robot 4. L'ouverture de sortie 14 est en forme de grille.

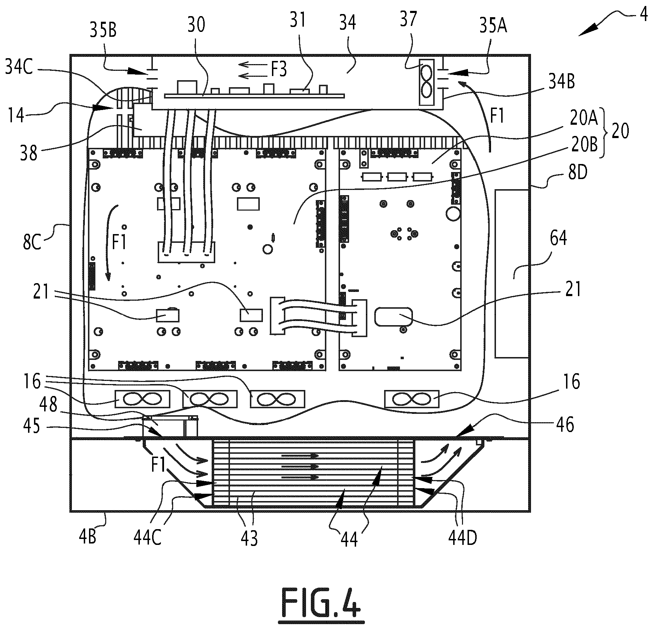

Le canal de refroidissement 10 comprend au moins un ventilateur 16 apte à aspirer l'air extérieur par l'ouverture d'entrée 12 du canal de refroidissement 10 et à le refouler vers l'extérieur par l'ouverture de sortie 14 du canal de refroidissement 10. De préférence, le ventilateur 16 est placé dans la deuxième portion 10B du canal de refroidissement 10. Avantageusement le canal de refroidissement 10 reçoit plusieurs ventilateurs 16, par exemple quatre ventilateurs 16 disposés sur toute la largeur de la face arrière 4C de l'armoire de contrôleur de robot 4 comme visible par arrachement sur la figure 4.

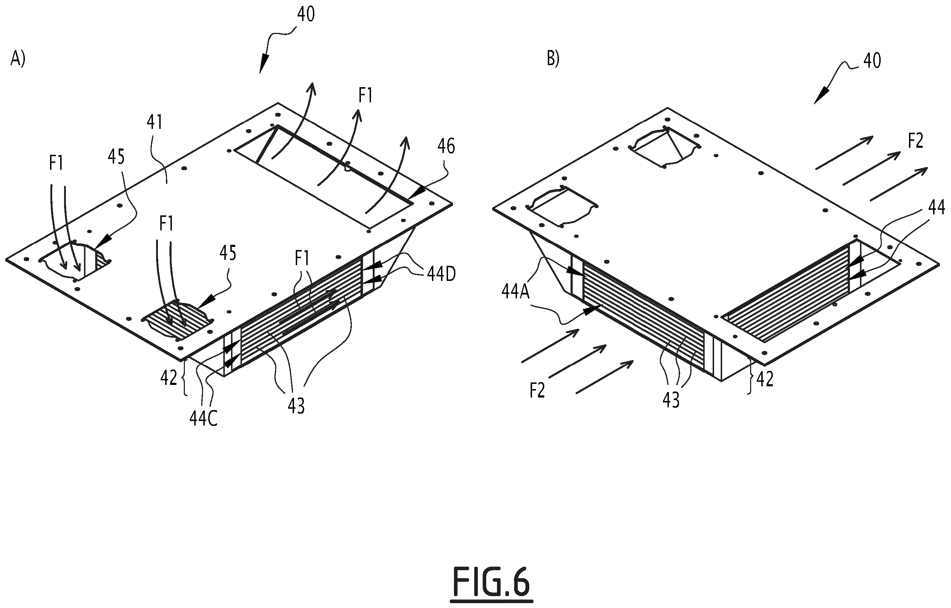

L'armoire de contrôleur de robot 4 comprend un échangeur air-air croisé 40. L'échangeur air-air croisé 40 est visible au sein de l'armoire de contrôleur de robot sur les figures 2, 4 et 5 et de manière isolée sur la figure 6. L'échangeur air-air croisé 40 est positionné dans une ouverture non représentée du panneau inférieur 8B de la chambre 8, de telle sorte qu'il est contenu dans la première portion 10A du canal de refroidissement 10, en regard de l'ouverture d'entrée 12 du canal de refroidissement 10.

L'échangeur air-air croisé 40 comprend un support 41 et un empilement 42 de plaques 43. Le support 41 vient fermer de façon hermétique l'ouverture du panneau inférieur 8B de la chambre 8.

Les plaques 43 sont des tôles de forme parallélépipédique. Les plaques 43 sont parallèles au support 41. Comme représenté sur la figure 6, les plaques 43 sont espacées de telle sorte à permettre un espace de passage 44 d'un flux d'air. En d'autres termes un espace de passage 44 de flux d'air est défini entre deux plaques 43 adjacentes.

Pour chaque espace de passage 44 de flux d'air, on définit une ouverture avant 44A parallèle à la face avant 4A de l'armoire de contrôleur de robot 4, une ouverture arrière 44B parallèle à la face arrière 4C de l'armoire de contrôleur de robot 4, une première ouverture latérale 44C parallèle au premier panneau latéral 8C et une deuxième ouverture latérale 44D parallèle au deuxième panneau latéral 8D.

Les espaces de passage 44 sont alternativement fermés sur leurs ouvertures avant 44A et arrière 44B ou sur leurs ouvertures latérales 44C et 44D. En d'autres termes, pour deux espaces de passage 44 adjacents, le premier espace de passage 44 permet l'écoulement d'un premier flux d'air F1 de sa première ouverture latérale 44C vers sa deuxième ouverture latérale 44D et le deuxième espace de passage 44 permet l'écoulement d'un deuxième flux d'air F2 de son ouverture avant 44A vers son ouverture arrière 44B.

Ces fermetures alternées des ouvertures des espaces de passages 44 créent deux circuits de refroidissement au sein de l'échangeur air-air croisé 40.

Le premier circuit de refroidissement comprend deux ouvertures d'entrée 45 traversant le support 41 du côté du panneau latéral 8C et qui sont connectées sous le support 41, en face des ouvertures latérales 44C des espaces de passage 44. Le premier circuit de refroidissement comprend une ouverture de sortie 46 traversant le support 41 et s'étendant parallèlement au panneau latéral 8D de la chambre 8. Le premier circuit de refroidissement comprend tous les espaces de passage 44 pour lesquels les ouvertures avant 44A et arrière 44B sont fermées.

En regard de chaque ouverture d'entrée 45 est positionné un ventilateur 48 qui refoule de l'air du volume intérieur V8 de la chambre 8 suivant le premier circuit de refroidissement. Les ventilateurs 48 sont positionnés dans le volume intérieur V8 de la chambre 8. Les ventilateurs 48 génèrent dans le premier circuit de refroidissement le flux d'air F1, représenté par des flèches sur les figures 4 et 6. Au sein de l'échangeur air-air croisé 40, le flux d'air F1 va des ouvertures d'entrée 45 jusqu'à l'ouverture de sortie 46 en passant par des espaces de passage 44. Dans une variante non représentée, le premier circuit de refroidissement comprend une unique ouverture d'entrée 45 traversant le support 41 et s'étendant parallèlement au panneau latéral 8C de la chambre 8. Dans ce cas, un unique ventilateur 48 est avantageusement prévu.

Dans une variante non représentée, le ou les ventilateurs 48 sont positionnés en regard de l'ouverture de sortie 46 du premier circuit de refroidissement.

Le deuxième circuit de refroidissement comprend une ouverture d'entrée formée par l'ensemble des ouvertures avants 44A des espaces de passage 44. L'ouverture d'entrée du deuxième circuit de refroidissement est donc en regard de l'ouverture d'entrée 12 du canal de refroidissement 10. Une ouverture de sortie du deuxième circuit de refroidissement est formée de l'ensemble des ouvertures arrières 44B des espaces de passage 44. L'ouverture de sortie du deuxième circuit de refroidissement est donc parallèle à l'ouverture d'entrée du deuxième circuit de refroidissement. L'ouverture de sortie du deuxième circuit de refroidissement débouche dans la première portion 10A du canal de refroidissement 10. Les ventilateurs 16 positionnés dans le canal de refroidissement 10 en aval de l'échangeur air-air croisé 40 génèrent au sein de l'échangeur air-air croisé 40 un flux d'air F2, représenté par des flèches sur les figures 5 et 6, allant de l'ouverture d'entrée du deuxième circuit de refroidissement vers l'ouverture de sortie du deuxième circuit de refroidissement, en passant par les espaces de passage 44 dont les ouvertures latérales 44C, 44D sont fermées.

Dans une variante non représentée, les ventilateurs 16 sont positionnés en amont de l'échangeur air-air croisé 40 et génère un flux d'air F2 analogue à celui décrit précédemment.

Ainsi au sein de l'échangeur air-air croisé 40, le flux d'air F1, s'écoulant au sein du premier circuit de refroidissement, s'écoule perpendiculairement au flux d'air F2, s'écoulant au sein du deuxième circuit de refroidissement.

L'armoire de contrôleur de robot 4 comprend des premières unités électroniques 20. Les premières unités électroniques 20 sont montées sur le panneau arrière 8E de la chambre 8, dans le volume intérieur V8 de la chambre 8. Ces premières unités électroniques 20 sont par exemple une unité d'alimentation 20A et une unité de puissance 20B.

La première unité électronique d'alimentation 20A est composée d'un ou plusieurs circuits imprimés comprenant au moins un composant à haute densité de chaleur 21 représenté symboliquement sur les figures, comme par exemple un transistor à effet de champ à grille isolée (en Anglais Metal Oxyde Semiconductor Field Effect Transistor), un thyristor ou un élément de convertisseur DC-DC qui convertit une source de courant continu d'un niveau de tension spécifié à un autre niveau de tension différent.. Un composant à haute densité de chaleur 21 est un composant électronique qui dissipe une puissance thermique importante compte tenu de ses dimensions. Cette dissipation de puissance importante étant concentrée sur une petite quantité de matière, elle entraîne une augmentation significative de la température du composant. Un composant éléctronique à haute densité de chaleur dissipe une puissance thermique allant par exemple de 20 Watt à 200 Watt.

La première unité électronique de puissance 20B est par exemple un amplificateur composé de circuits imprimés comprenant au moins un composant à haute densité de chaleur 21 tel qu'un module de commutation. De préférence le module de commutation est un transistor bipolaire à grille isolée (en Anglais Insulated-Gate Bipolar Transistor).

La première unité électronique de puissance 20B est apte à générer les courants dans les moteurs du bras de robot 2 à partir des consignes de commande d'amplificateurs et des informations de positions des moteurs du bras de robot 2.

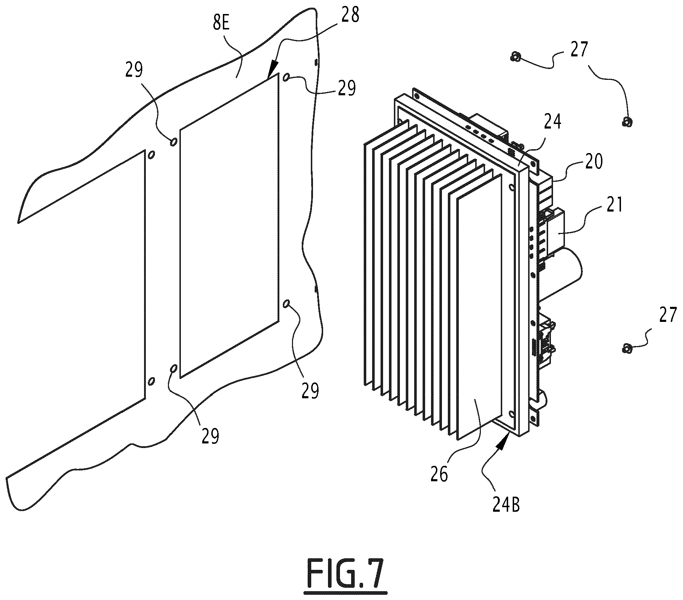

Les premières unités électroniques 20 comprennent des composants à haute densité de chaleur 21. Pour améliorer l'évacuation de la chaleur produite par ces composants à haute densité de chaleur 21, chaque première unité électronique 20 est montée sur un premier côté 24A d'un échangeur thermique air-composant 24. L'échangeur thermique air-composant 24 porte sur un deuxième côté 24B un élément de refroidissement 26 comme visible sur les figures 5 et 7. L'élément de refroidissement 26 est par exemple un ensemble d'ailettes. L'élément de refroidissement 26 est constitué d'un matériau à forte conduction thermique comme, par exemple l'aluminium.

L'échangeur thermique air-composant 24 est positionné dans une ouverture 28 du panneau arrière 8E de telle sorte que les premières unités électroniques 20 sont dans le volume intérieur V8 de la chambre 8 et l'élément de refroidissement 26 est dans la deuxième portion 10B du canal de refroidissement 10. L'échangeur thermique air-composant 24 est fixé au panneau arrière 8E par l'intermédiaire de vis 27 prises dans des trous taraudés 29 et vient fermer de façon hermétique l'ouverture 28 du panneau arrière 8E. De manière avantageuse, l'échangeur thermique air-composant 24 est positionné de telle sorte que, dans le canal de refroidissement 10, l'élément de refroidissement 26 est en aval des ventilateurs 16.

Le panneau arrière 8E comprend autant d'ouverture 28 que de premières unités électroniques 20.

L'armoire de contrôleur de robot 4 comprend une deuxième unité électronique 30. Par exemple, la deuxième unité électronique 30 génère les consignes de commande destinées aux premières unités électroniques de puissance 20B qui vont permettre le bon actionnement des moteurs du bras de robot 2 en vue de l'action à réaliser par le bras de robot 2.

La deuxième unité électronique 30 comprend au moins un composant à densité de chaleur modérée 31. De préférence, la deuxième unité électronique 30 est une unité de calcul et le composant à densité de chaleur modérée 31 est, par exemple, un processeur. Un composant à densité de chaleur modérée 31 est un composant électronique qui dissipe une puissance thermique faible mais dont l'augmentation de température doit être limitée pour qu'il fonctionne correctement, c'est-à-dire qui dissipe une puissance thermique inférieure à 35 Watt.

La deuxième unité électronique 30 est disposée à l'intérieur d'un premier tiroir 34. Le premier tiroir 34 est pourvu d'un châssis parallélépipédique. Le premier tiroir 34 est porté par le panneau supérieur 8A, dans le volume intérieur V8 de la chambre 8.

Le premier tiroir 34 est préférentiellement monté sur des rails non représentés et parallèles aux panneaux latéraux 8C, 8D de la chambre 8. Le premier tiroir 34 peut coulisser sur les rails, ce qui permet un démontage facile du premier tiroir 34 par la porte avant 9B de l'armoire de contrôleur de robot 4.

Le tiroir 34 comprend une première ouverture 34A ménagée sur une de ses faces, de préférence sur la face en regard du panneau arrière 8E. Cette première ouverture 34A permet le passage des câbles de connexion 36 de la deuxième unité électronique 30 vers la première unité électronique 20.

Le premier tiroir 34 comprend un ventilateur interne 37 qui génère un flux d'air F3 interne au premier tiroir 34. Le flux d'air interne F3 s'écoule entre une première ouverture 35A ménagée sur une première face latérale 34B du premier tiroir 34 en regard du panneau latéral 8D vers une deuxième ouverture 35B ménagée sur une deuxième face latérale 34C du premier tiroir 34 en regard du panneau latéral 8C. Le flux d'air F3 se superpose au flux d'air F1 qui pénètre dans le premier tiroir 34 grâce à la première ouverture 35A et ressort grâce à la deuxième ouverture 35B. Les flux d'air F1 et F3 dissipent la chaleur produite, à l'intérieur du premier tiroir 34, par les composants à densité de chaleur modérée 31 vers le volume intérieur V8 de la chambre 8 qui est plus important que le volume du tiroir 34 dans lequel sont positionnés les composants à densité de chaleur modérée 31.

L'armoire de contrôleur de robot 4 comprend une deuxième unité électronique 30 constitué d'une unité de filtrage 64 fixée sur le panneau latéral 8D. L'unité de filtrage 64 est placée entre le réseau électrique et l'unité d'alimentation 20A et a pour fonction de filtrer toutes les perturbations électriques. Elle contient des composants électroniques à densité de chaleur modérée 31 comme par exemple un composant de filtrage passif.

L'armoire de contrôleur de robot 4 comprend une résistance de freinage 38. La résistance de freinage 38 est montée sur le panneau arrière 8E de la chambre 8 dans le canal de refroidissement 10. En d'autres termes, la résistance de freinage 38, qui est visible sur les figures 2 et 4, est à l'extérieur du volume intérieur V8 de la chambre 8. La résistance de freinage 38 est disposée en regard de l'ouverture de sortie 14 du canal de refroidissement 10. La résistance de freinage 38 est alimentée par la première unité électronique de puissance 20B lorsque les moteurs du bras de robot 2 restituent de l'énergie. En d'autres termes, la résistance de freinage 38 dissipe le surplus d'énergie produit par la première unité électronique de puissance 20B.

Lorsque le robot R est en fonctionnement, les composants à haute densité de chaleur 21 produisent de la chaleur qui doit être évacuée pour permettre aux composants à densité de chaleur modérée 31 de fonctionner correctement.

Les ventilateurs 48 génèrent un flux d'air F1. Le flux d'air F1 rentre dans l'échangeur air-air croisé 40 par les ouvertures 44C des espaces de passage 44 et ressort par les ouvertures 44D. Le flux d'air F1 pénètre ensuite dans la chambre 8 au travers de l'ouverture de sortie 46. Dans le volume intérieur V8 de la chambre 8, le flux d'air F1 suit le panneau latéral 8D puis le premier tiroir 34, puis le panneau latéral 8C jusqu'à l'ouverture 45 au niveau du panneau inférieur 8B. Le flux d'air F1 effectue donc un cycle au sein du volume intérieur V8 de la chambre 8.

Le flux d'air F3 interne au premier tiroir 34 est de même direction que le flux d'air F1.

Le flux d'air F1 assure la dissipation thermique de la chaleur générée par les composants électroniques à densité de chaleur modérée 31. Le flux d'air F1 est refroidi par le flux d'air F2 lors de son passage dans l'échangeur air-air croisé 40.

Les ventilateurs 16 du canal de refroidissement 10 génèrent le flux d'air F2 de l'ouverture d'entrée 12 du canal de refroidissement 10 vers l'ouverture de sortie 14 du canal de refroidissement 10. Le flux d'air F2 passe au travers des espaces de passage 44 au sein de l'échangeur air-air croisé 40. Comme l'échangeur air-air croisé 40 est placé à l'entrée du canal de refroidissement 10, la température du flux d'air F2 à l'entrée de l'échangeur air-air croisé 40 est celle de l'air ambiant et est inférieure à la température de l'air souhaitée dans la chambre 8 qui est de l'ordre de 55 degrés Celsius. Le flux d'air F2 est apte à refroidir le flux d'air F1. Après son passage dans l'échangeur air-air 40, le flux d'air F2 est en contact dans le canal de refroidissement 10 des éléments de refroidissement 26 des échangeurs thermiques air-composant 24 dont la température peut atteindre 85 degrés Celsius. La chaleur générée par les composants électroniques à haute densité de chaleur 21 est collectée par les échangeurs thermiques air-composants 24 et est dissipée par le flux d'air F2 dans le canal de refroidissement 10 car la température de l'air du flux d'air F2 au niveau des échangeurs thermiques air-composants 24 est inférieure à la température des éléments de refroidissement 26 des échangeurs thermiques air-composant 24.

Comme le flux d'air F2 croise le flux d'air F1 et est en contact des éléments de refroidissement 26 des échangeurs thermiques air-composants 24, il assure à la fois la dissipation thermique de la chaleur générée par les composants électroniques à haute densité de chaleur 21 et la dissipation thermique de la chaleur générée par les composants électroniques à densité de chaleur modérée 31.

Avantageusement, dans certaines applications où il peut être nécessaire d'empiler plusieurs armoires de contrôleur de robot 4, l'écoulement du flux d'air F2 permet d'assurer que la production de chaleur d'une première armoire de contrôleur de robot 4 évacuée par l'ouverture de sortie 14 n'impacte pas le refroidissement d'une deuxième armoire 4 positionnée au-dessus ou en dessous.

L'action conjuguée des flux d'air F1 et F2 permet de dissiper la chaleur générée par les composants à haute densité de chaleur 21 et de maintenir dans le volume intérieur V8 de la chambre 8 une température correcte de fonctionnement pour les éléments à densité de chaleur modérée 31.

Grâce à l'échangeur air-air croisé 40 qui permet un échange thermique entre les deux flux d'air F1 et F2, la chaleur produite par les premières unités électroniques 20 affecte de façon limitée les deuxièmes unités électroniques 30.

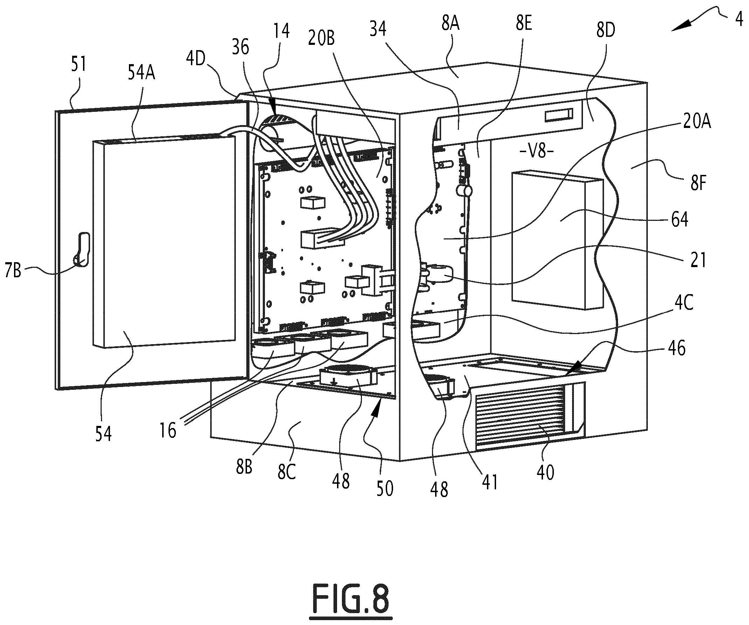

Dans le deuxième mode de réalisation représenté à la figure 8, les éléments analogues à ceux du premier mode de réalisation portent les mêmes références. Si une référence est utilisée dans la suite de la description sans être portée sur la figure 8 ou portée sur la figure 8 sans être mentionnée dans la description, elle désigne le même élément que celui portant la même référence dans le premier mode de réalisation. Dans ce qui suit, on décrit principalement ce qui distingue ce deuxième mode de réalisation du premier.

Dans le deuxième mode de réalisation, le panneau latéral 8C comprend une ouverture 50 fermée par une porte latérale 51. La porte latérale 51 permet, en position ouverte, d'accéder au volume intérieur V8 de la chambre 8.

Le panneau avant 8F ne comporte qu'une seule ouverture correspondant à l'ouverture d'entrée 12 du canal de refroidissement 10.

L'ouverture de sortie 14 du canal de refroidissement 10 est ménagée sur un pan oblique 4D de l'armoire de contrôleur de robot 4. Le pan oblique 4D s'étend entre le panneau supérieur de la chambre 8A et la face arrière 4C de l'armoire de contrôleur de robot 4.

Le premier tiroir 34 est préférentiellement monté sur des rails non représentés et parallèles aux panneaux avant 8F et arrière 8E de la chambre 8. Le premier tiroir 34 peut coulisser sur les rails ce qui permet un démontage facile du premier tiroir 34 par la porte latérale 51 de l'armoire de contrôleur de robot 4.

La porte 51 comprend sur sa face interne 51A, en regard du volume intérieur V8 de la chambre 8, un deuxième tiroir 54. Une deuxième unité électronique 30 est positionnée à l'intérieur du deuxième tiroir 54. Le deuxième tiroir 54 comprend une ouverture sur une de ses faces, de préférence sur sa face supérieure 54A en regard du panneau supérieur 8A de la chambre 8, qui permet le passage d'un câble de connexion 36 vers les premières 20 et deuxièmes 30 unités électroniques situées en dehors du tiroir 54.

Les deuxièmes unités électroniques 30 sont donc contenues dans un premier tiroir 34 et/ou un deuxième tiroir 54.

En d'autres termes, la deuxième unité électronique 30 est placée sur le panneau supérieur 8A de la chambre 8 et/ou est portée par la porte 51 du panneau latéral 8C.

Le flux d'air F1 généré pour assurer la dissipation thermique des composants électroniques à densité de chaleur modérée 31 effectue un cycle dans la chambre 8 analogue à celui décrit précédemment. Dans le volume intérieur V8 de la chambre 8, le flux d'air F1 pénètre au travers de l'ouverture de sortie 46, puis suit le panneau latéral 8D puis le premier tiroir 34 puis le deuxième tiroir 54 jusqu'aux ouvertures 45 au niveau du panneau inférieur 8B.

Dans une variante non représentée, l'unité de filtrage 64 est fixée sur le panneau latéral 8C et le panneau latéral 8D comprend une ouverture 50 fermée par une porte 51.

Les avantages de l'invention découle de l'emploi d'un échangeur air-air croisé 40 qui permet de mettre en place un flux d'air F1 interne à une unique chambre 8 qui parcourt des panneaux latéraux 8C et 8D et un panneau supérieur 8A et un flux d'air F2 ouvert perpendiculaire au flux d'air F1 et qui parcourt un panneau arrière 8E. Il est alors possible d'avoir dans la même chambre 8 deux régimes de refroidissement distincts. Des premières unités électroniques 20 montées sur le panneau arrière 8E de la chambre 8 et comprenant des composants électroniques à haute densité de chaleur 21 sont principalement refroidies par le flux d'air F2 et des deuxièmes unités électroniques 30 montées sur le ou les panneaux latéraux 8C ou 8D ou le panneau supérieur 8A et comprenant des composants électroniques à densité de chaleur modérée 31 sont principalement refroidies par le flux d'air 1. Le flux d'air 1 permet de maintenir l'air de la chambre 8 à une température compatible avec le fonctionnement des composants électroniques à densité de chaleur modérée équipant des deuxièmes unités électroniques 30 mais aussi des premières unités électroniques 20 comme cela peut être le cas.

Pour autant que cela est techniquement réalisable, les modes de réalisation et variantes mentionnés ci-dessus peuvent être combinés entre eux.

## Revendications

1. Armoire de contrôleur de robot comprenant :
- une chambre (8) définie par un panneau supérieur (8A), un panneau inférieur (8B), deux panneaux latéraux (8C, 8D), un panneau arrière (8E) et un panneau avant (8F) placé en regard du panneau arrière (8E) et définissant une face avant (4A) de l'armoire de contrôleur de robot (4),
- au moins une première unité électronique (20) montée sur le panneau arrière (8E) de la chambre (8), à l'intérieur de la chambre, et comprenant au moins un composant électronique à haute densité de chaleur (21),
- au moins une deuxième unité électronique (30) montée sur le ou les panneaux latéraux (8C, 8D) ou le panneau supérieur (8A), à l'intérieur de la chambre (8), et comprenant au moins un composant électronique à densité de chaleur modérée (31),
- un canal de refroidissement (10) comprenant
• une ouverture d'entrée (12),
• au moins un ventilateur (16) apte à aspirer l'air extérieur par l'ouverture d'entrée (12) du canal de refroidissement (10) et à le refouler vers l'extérieur par une ouverture de sortie (14) située à l'extrémité opposée à l'ouverture d'entrée (12) du canal de refroidissement (10),
- au moins un échangeur thermique air-composant (24) associé à une première unité électronique (20) et recevant, sur un premier côté, au moins un composant électronique à haute densité de chaleur (21) et, portant sur un deuxième côté, au moins un élément de refroidissement (26), disposé dans le canal de refroidissement (10),
où
- le canal de refroidissement (10) comprend
• une première portion (10A) définie entre le panneau inférieur (8B) de la chambre (8) et un panneau parallèle extérieur (4B) définissant un fond de l'armoire de contrôleur de robot (4),
• une deuxième portion (10B) contigüe à la première portion (10A), située entre le panneau arrière (8E) de la chambre (8) et un panneau parallèle extérieur (4C) définissant une face arrière de l'armoire de contrôleur de robot (4),
- l'ouverture d'entrée (12) du canal de refroidissement (10) est ménagée sur la face avant (4A) de l'armoire (4),
- un échangeur air-air croisé (40) est disposé dans le canal de refroidissement (10) et comprend :
• un premier circuit de refroidissement présentant une ouverture d'entrée (45) traversant le panneau inférieur (8B) de la chambre (8) et une ouverture de sortie (46) traversant le panneau inférieur (8B) de la chambre (8),
• un deuxième circuit de refroidissement présentant une ouverture d'entrée (44A) en regard de l'ouverture d'entrée (12) du canal de refroidissement (10) et une ouverture de sortie (44B) parallèle à l'ouverture d'entrée (44A) du deuxième circuit de refroidissement, étant agencée à l'extrémité opposé de l'échangeur air-air croisé (40) et débouchant dans le canal de refroidissement (10),
- au moins un ventilateur (48), situé à l'intérieur de la chambre (8) en regard de l'ouverture d'entrée (45) ou de l'ouverture de sortie (46) du premier circuit de refroidissement de l'échangeur air-air croisé (40), génère, dans le premier circuit de refroidissement, un flux d'air (F1) perpendiculaire à un flux d'air (F2) généré dans le deuxième circuit de refroidissement par le ventilateur (16) du canal de refroidissement (10).

2. Armoire de contrôleur de robot selon la revendication 1, **caractérisée en ce que** le ventilateur (16) du canal de refroidissement (10) est placé en aval de l'échangeur air-air croisé (40), en amont de l'échangeur thermique air-composant (24) et dans la deuxième portion (10B) du canal de refroidissement (10).

3. Armoire de contrôleur de robot selon l'une des revendications 1 et 2, **caractérisée en ce que** la première unité électronique (20) est un amplificateur et le composant à haute densité de chaleur (21) est un module de commutation, de préférence un transistor bipolaire à grille isolée.

4. Armoire de contrôleur de robot selon l'une des revendications 1 à 3, **caractérisée en ce que** la première unité électronique (20) est une alimentation et le composant à haute densité de chaleur (21) est un transistor à effet de champ à grille isolée ou un thyristor ou un élément de convertisseur DC-DC qui convertit une source de courant continu d'un niveau de tension spécifié à un autre niveau de tension différent.

5. Armoire de contrôleur de robot selon l'une quelconque des revendications précédentes, **caractérisée en ce que** :
- la deuxième unité électronique (30) est une unité de calcul et le composant à densité de chaleur modérée (31) est un processeur ou
- la deuxième unité électronique est une unité de filtrage (64) et le composant à densité de chaleur modérée est un composant passif de filtrage.

6. Armoire de contrôleur de robot selon l'une quelconque des revendications précédentes, **caractérisée en ce que** l'armoire de contrôleur de robot (4) comprend une résistance de freinage (38), montée sur le panneau arrière (8E) de la chambre (8) dans le canal de refroidissement (10) en aval de l'échangeur thermique air-composant (24), configurée pour dissiper un surplus d'énergie produit par la première unité électronique (20).

7. Armoire de contrôleur de robot selon l'une quelconque des revendications précédentes, **caractérisée en ce que** l'ouverture de sortie (14) du canal de refroidissement (10) est ménagée sur la face arrière (4C) de l'armoire de contrôleur de robot (4).

8. Armoire de contrôleur de robot selon l'une quelconque des revendications précédentes, **caractérisée en ce que** la deuxième unité électronique (30) est disposée à l'intérieur d'un premier tiroir (34) porté par le panneau supérieur (8A) de la chambre (8), le premier tiroir (34) comprenant une première ouverture (35A), disposée en regard d'une face latérale (8D) de la chambre (8), et une deuxième ouverture (35B) disposée en regard de l'autre face latérale (8C) de la chambre (8).

9. Armoire de contrôleur de robot selon l'une quelconque des revendications 1 à 7, **caractérisée en ce qu'**un panneau latéral (8C, 8D) de la chambre (8) comprend une ouverture (50) fermée par une porte (51) et **en ce que** la deuxième unité électronique (30) est placée sur le panneau supérieur (8A) de la chambre (8) et/ou est portée par la porte (51) du panneau latéral (8C, 8D).

10. Robot multi-axes comprenant :
- un bras de robot (2) articulé à au moins deux degrés de liberté,
- une armoire de contrôleur de robot (4) selon l'une des revendications 1 à 9,
- des câbles (6) reliant le bras de robot (2) à l'armoire de contrôleur de robot (4).

## Patentansprüche

1. Robotersteuerungsschrank, umfassend:
- eine Kammer (8), die durch eine obere Platte (8A), eine untere Platte (8B), zwei Seitenplatten (8C, 8D), eine hintere Platte (8E) und eine vordere Platte (8F) definiert ist, die gegenüber der hinteren Platte (8E) platziert ist und eine Vorderseite (4A) des Robotersteuerungsschranks (4) definiert,
- mindestens eine erste elektronische Einheit (20), die an der Rückwand (8E) der Kammer (8) im Inneren der Kammer montiert ist, und umfassend mindestens eine elektronische Komponente (21) mit hoher Wärmedichte umfasst,
- mindestens eine zweite elektronische Einheit (30), die an der oder den Seitenplatten (8C, 8D) oder der oberen Platte (8A) im Innern der Kammer (8) montiert ist, und umfassend mindestens eine elektronische Komponente (31) mit moderater Wärmedichte,
- einen Kühlkanal (10), umfassend
• eine Einlassöffnung (12),
• mindestens einen Lüfter (16), der angepasst ist, um Außenluft durch die Einlassöffnung (12) des Kühlkanals (10) anzusaugen und sie durch eine Auslassöffnung (14), die sich an dem der Einlassöffnung (12) des Kühlkanals (10) gegenüberliegenden Ende befindet, nach außen zu fördern,
- mindestens einen Luft-Komponente-Wärmetauscher (24), der einer ersten elektronischen Einheit (20) assoziiert ist und auf einer ersten Seite mindestens eine elektronische Komponente mit hoher Wärmedichte (21) aufnimmt und, auf einer zweiten Seite tragend, mindestens ein Kühlelement (26) aufnimmt, das in dem Kühlkanal (10) angeordnet ist,
wobei
- der Kühlkanal (10) Folgendes umfasst
• einen ersten Abschnitt (10A), der zwischen der unteren Platte (8B) der Kammer (8) und einer äußeren parallelen Platte (4B), die einen Boden des Robotersteuerungsschranks (4) definiert, definiert ist,
• einen zweiten Abschnitt (10B), der an den ersten Abschnitt (10A) angrenzt und sich zwischen der Rückwand (8E) der Kammer (8) und einer parallelen Außenwand (4C) befindet, die eine Rückseite des Robotersteuerungsschranks (4) definiert,
- wobei die Einlassöffnung (12) des Kühlkanals (10) an der Vorderseite (4A) des Gehäuses (4) ausgebildet ist,
- ein gekreuzter Luft-Luft-Austauscher (40) in dem Kühlkanal (10) angeordnet ist und Folgendes umfasst:
• einen ersten Kühlkreislauf, der eine Einlassöffnung (45), die die untere Platte (8B) der Kammer (8) durchquert, und eine Auslassöffnung (46), die die untere Platte (8B) der Kammer (8) durchquert, aufweist,
• einen zweiten Kühlkreislauf, der eine Einlassöffnung (44A) gegenüber der Einlassöffnung (12) des Kühlkanals (10) und eine Auslassöffnung (44B) parallel zu der Einlassöffnung (44A) des zweiten Kühlkreislaufs aufweist, die an dem gegenüberliegenden Ende des gekreuzten Luft-Luft-Wärmetauschers (40) ausgebildet ist und in den Kühlkanal (10) mündet,
- wobei mindestens ein Lüfter (48), der sich im Inneren der Kammer (8) gegenüber der Einlassöffnung (45) oder der Auslassöffnung (46) des ersten Kühlkreislaufs des gekreuzten Luft-Luft-Austauschers (40) befindet, in dem ersten Kühlkreislauf einen Luftstrom (F1) erzeugt, der senkrecht zu einem Luftstrom (F2) ist, der in dem zweiten Kühlkreislauf durch den Lüfter (16) des Kühlkanals (10) erzeugt wird.

2. Robotersteuerungsschrank nach Anspruch 1, **dadurch gekennzeichnet, dass** der Lüfter (16) des Kühlkanals (10) stromabwärts von dem gekreuzten Luft-Luft-Wärmetauschers (40), stromaufwärts von dem Wärmetauscher-Luft-Komponente (24) und in dem zweiten Abschnitt (10B) des Kühlkanals (10) platziert ist.

3. Robotersteuerungsschrank nach einem der Ansprüche 1 oder 2, **dadurch gekennzeichnet, dass** die erste elektronische Einheit (20) ein Verstärker ist und die Komponente mit hoher Wärmedichte (21) ein Schaltmodul, vorzugsweise ein bipolarer Transistor mit isoliertem Gate, ist.

4. Robotersteuerungsschrank nach einem der Ansprüche 1 bis 3, **dadurch gekennzeichnet, dass** die erste elektronische Einheit (20) ein Netzteil ist und die Komponente mit hoher Wärmedichte (21) ein Feldeffekttransistor mit isoliertem Gate oder ein Thyristor oder ein DC-DC-Wandlerelement ist, das eine Gleichstromquelle von einem spezifizierten Spannungspegel auf einen anderen, verschiedenen Spannungspegel umwandelt.

5. Robotersteuerungsschrank nach einem der vorherigen Ansprüche, **dadurch gekennzeichnet, dass**:
- die zweite elektronische Einheit (30) eine Recheneinheit ist und die Komponente mit moderater Wärmedichte (31) ein Prozessor ist oder
- die zweite elektronische Einheit eine Filtereinheit (64) ist und die Komponente mit moderater Wärmedichte eine passive Filterkomponente ist.

6. Robotersteuerungsschrank nach einem der vorherigen Ansprüche, **dadurch gekennzeichnet, dass** der Robotersteuerungsschrank (4) einen Bremswiderstand (38) umfasst, der an der Rückwand (8E) der Kammer (8) in dem Kühlkanal (10) stromabwärts von dem Wärmetauscher-Luft-Komponente (24) montiert und konfiguriert ist, um überschüssige Energie, die von der ersten elektronischen Einheit (20) erzeugt wird, abzuführen.

7. Robotersteuerungsschrank nach einem der vorherigen Ansprüche, **dadurch gekennzeichnet, dass** die Auslassöffnung (14) des Kühlkanals (10) an der Rückseite (4C) des Robotersteuerungsschranks (4) ausgebildet ist.

8. Robotersteuerungsschrank nach einem der vorherigen Ansprüche, **dadurch gekennzeichnet, dass** die zweite elektronische Einheit (30) im Inneren eines ersten Schiebers (34) angeordnet ist, die von der oberen Platte (8A) der Kammer (8) getragen wird, wobei der erste Schieber (34) eine erste Öffnung (35A), die gegenüber einer Seitenfläche (8D) der Kammer (8) angeordnet ist, und eine zweite Öffnung (35B), die gegenüber der anderen Seitenfläche (8C) der Kammer (8) angeordnet ist, umfasst.

9. Robotersteuerungsschrank nach einem der Ansprüche 1 bis 7, **dadurch gekennzeichnet, dass** eine Seitenwand (8C, 8D) der Kammer (8) eine Öffnung (50) umfasst, die durch eine Tür (51) verschlossen ist, und dass die zweite elektronische Einheit (30) an der oberen Wand (8A) der Kammer (8) platziert ist und/oder von der Tür (51) der Seitenwand (8C, 8D) getragen wird.

10. Mehrachsenroboter, umfassend:
- einen Roboterarm (2), der in mindestens zwei Freiheitsgraden angelenkt ist,
- einen Robotersteuerungsschrank (4) nach einem der Ansprüche 1 bis 9,
- Kabel (6), die den Roboterarm (2) mit dem Robotersteuerungsschrank (4) verbinden.

## Claims

1. A robot controller cabinet comprising:
- a chamber (8) defined by a top panel (8A), a bottom panel (8B), two lateral panels (8C, 8D), a rear panel (8E), and a front panel (8F) arranged opposite the rear panel (8E) and defining a front side (4A) of the robot controller cabinet (4),
- at least one first electronic unit (20) mounted on the rear panel (8E) of the chamber (8) within the chamber and comprising at least one electronic component with a high heat flux (21),
- at least one second electronic unit (30) mounted on one or more of the lateral panels (8C, 8D) or the top panel (8A) inside the chamber (8) and comprising at least one electronic component with a moderate heat flux (31),
- a cooling channel (10) comprising:
• an inlet opening (12),
• at least one fan (16) apt to draw in outside air through the inlet opening (12) of the cooling channel (10) and discharging same outwards through an outlet opening (14) located at the end opposite the inlet opening (12) of the cooling channel (10),
- at least one air-to-component heat exchanger (24) associated with a first electronic unit (20) and accommodating on a first side, at least one electronic component with a high heat flux (21) and supporting, on a second side, at least one cooling element (26), arranged in the cooling channel (10),
wherein:
- the cooling channel (10) comprises
• a first portion (10A) defined between the bottom panel (8B) of the chamber (8) and an outer parallel panel (4B) defining a bottom of the robot controller cabinet (4),
• a second portion (10B) contiguous to the first portion (10A), located between the rear panel (8E) of the chamber (8) and an outer parallel panel (4C) defining a rear side of the robot controller cabinet (4),
- the inlet opening (12) of the cooling channel (10) is provided on the front side (4A) of the cabinet (4),
- an air-air cross-flow exchanger (40) is arranged in the cooling channel (10) and comprises:
• a first cooling circuit having an inlet opening (45) through the bottom panel (8B) of the chamber (8) and an outlet opening (46) through the bottom panel (8B) of the chamber (8),
• a second cooling circuit having an inlet opening (44A) opposite the inlet opening (12) of the cooling channel (10) and an outlet opening (44B) parallel to the inlet opening (44A) of the second cooling circuit, being arranged at the opposite end of the air-air cross-flow exchanger (40) and opening into the cooling channel (10),
- at least one fan (48), located inside the chamber (8) opposite the inlet opening (45) or the outlet opening (46) of the first cooling circuit of the air-air cross-flow exchanger (40), generates, in the first cooling circuit, an airflow (F1) perpendicular to an airflow (F2) generated in the second cooling circuit by the fan (16) of the cooling channel (10).

2. The robot controller cabinet according to claim 1, **characterized in that** the fan (16) of the cooling channel (10) is arranged downstream of the air-air cross-flow exchanger (40), upstream of the air-to-component heat exchanger (24) and in the second portion (10B) of the cooling channel (10).

3. The robot controller cabinet according to one of claims 1 and 2, **characterized in that** the first electronic unit (20) is an amplifier and the component with a high heat flux (21) is a switching module, preferably an insulated-gate bipolar transistor.

4. The robot controller cabinet according to one of claims 1 to 3, **characterized in that** the first electronic unit (20) is a power supply and the component with a high heat flux (21) is an insulated-gate field effect transistor or a thyristor or a DC-DC converter element that converts a DC source to a specified level of voltage into another different level of voltage.

5. The robot controller cabinet according to one of the preceding claims, **characterized in that**:
- the second electronic unit (30) is a computing unit and the component with a moderate heat flux (31) is a processor or
- the second electronic unit is a filtering unit (64) and the component with a moderate heat flux is a passive filtering component.

6. The robot controller cabinet according to any of the preceding claims, **characterized in that** the robot controller cabinet (4) comprises a braking resistor (38), mounted on the rear panel (8E) of the chamber (8) in the cooling channel (10) downstream of the air-to-component heat exchanger (24), configured to dissipate excess energy produced by the first electronic unit (20).

7. The robot controller cabinet according to one of the preceding claims, **characterized in that** the outlet opening (14) of the cooling channel (10) is provided on the rear side (4C) of the robot controller cabinet (4).

8. The robot controller cabinet according to one of the preceding claims, **characterized in that** the second electronic unit (30) is arranged inside a first rack unit (34) supported by the top panel (8A) of the chamber (8), the first rack unit (34) comprising a first opening (35A), arranged opposite a lateral side (8D) of the chamber (8), and a second opening (35B) arranged opposite the other lateral side (8C) of the chamber (8).

9. The robot controller cabinet according to one of claims 1 to 7, **characterized in that** a lateral panel (8C, 8D) of the chamber (8) comprises an opening (50) closed by a door (51) and the second electronic unit (30) is placed on the top panel (8A) of the chamber (8) and/or is supported by the door (51) of the lateral panel (8C, 8D).

10. A multi-axis robot comprising:
- a robot arm (2) articulated to at least two degrees of freedom,
- a robot controller cabinet (4) according to one of claims 1 to 9,
- cables (6) connecting the robot arm (2) to the robot controller cabinet (4).
